# EUROPEAN PATENT APPLICATION

(11) **EP 4 729 669 A1**
(43) Date of publication of application: **22.04.2026**
(21) Application number: 24825768.5
(22) Date of filing: 10.06.2024
(51) Int. Cl.: C30B 29/36, C30B 33/02, C30B 33/06, H01L 21/02, H01L 21/20, H01L 21/31, H01L 21/205, H01L 21/265

(54) **METHOD FOR MANUFACTURING SIC SUBSTRATE, METHOD FOR MANUFACTURING SEMICONDUCTOR DEVICE, SIC SUBSTRATE, AND SEMICONDUCTOR DEVICE**

(30) Priority: 19.06.2023 JP 2023099978
(71) Applicant: Shin-Etsu Handotai Co., Ltd., Tokyo 100-0004 (JP)
(72) Inventor: OHTSUKI, Tsuyoshi, Nishishirakawa-gun, Fukushima 961-8061 (JP); MATSUBARA, Toshiki, Nishishirakawa-gun, Fukushima 961-8061 (JP); ABE, Tatsuo, Nishishirakawa-gun, Fukushima 961-8061 (JP)
(74) Representative: Schicker, Silvia
(86) International application number: PCT/JP2024/020997
(87) International publication number: WO 2024/262363

(57) **Abstract**

The present invention is a method for producing a SiC substrate 100, the method including the steps of bonding a 3C-SiC layer 1a of a growth substrate 21, in which the 3C-SiC layer 1a has been grown on a silicon substrate 1, to a poly-SiC substrate, being a support substrate 3, to obtain a bonded substrate 10, removing the silicon substrate 1 from the bonded substrate 10, and a heat treatment of further subjecting the bonded substrate 10 after the step of removing to a heat treatment to induce a phase transition of the 3C-SiC layer 1a, thereby obtaining the SiC substrate 100 having a SiC layer 1b with a plane orientation different from a plane orientation prior to the heat treatment. This provides a method for producing a SiC substrate to achieve both an increase in diameter and accommodation of various polytypes of SiC.

## Description

### TECHNICAL FIELD

The present invention relates to a method for producing a SiC substrate, a method for producing a semiconductor module, a SiC substrate, and a semiconductor module.

### BACKGROUND ART

SiC is expected to be a semiconductor material for a variety of semiconductor devices, such as power devices and high-frequency devices. This is due to the characteristics of SiC having multiple crystal structures and, depending on these crystal structures, a wide bandgap of 2.2 to 3.3 eV, which results in a high dielectric breakdown strength and high thermal conductivity.

Among multiple crystal structures (polytypes), 4H-SiC has been grown as a crystal using methods such as a sublimation method and a gas phase method, and has been put into practical use. However, because 4H-SiC is grown as a crystal by sublimation or a vapor-phase method, it is difficult to increase the wafer diameter. SiC, due to favorable thermal properties thereof, is expected to have a wide range of applications, such as free wheeling diodes in power units, and therefore, enlargement of the wafer diameter of SiC is desired.

In fact, it has been reported that in the devices using SiC, the production step of SiC substrates and the subsequent epitaxial step account for half of the cost (Non-Patent Document 1). Consequently, the reduction of cost through diameter enlargement is extremely important.

A method for reducing the cost has been proposed by implanting H⁺ ions into a single crystal SiC substrate to perform substrate separation. Patent Document 1, for example, discloses employing a polycrystalline SiC as a target substrate for transfer in this method.

In addition, Patent Document 2 further discloses that SiC is further epitaxially grown on a single crystal SiC, which has been transferred. Moreover, a method is disclosed for producing a SiC composite substrate by steps in the following order: growing a preexisting single crystal SiC on a silicon substrate; growing a polycrystalline SiC on this single crystal SiC layer by chemical vapor deposition; and heating a resultant laminate to 1414°C or higher to melt the silicon substrate (Patent Document 3).

Moreover, Patent Document 4 discloses a method in which 3C-SiC is grown on a silicon substrate to be transferred onto a support substrate and then to be epitaxially grown. In particular, 3C-SiC is a material capable of epitaxial growth at low temperature and can be grown on a silicon substrate.

However, materials grown on silicon substrates are difficult to apply to, in particular, vertical devices, such as those used in power devices. A method for producing a SiC substrate by bonding and separating can provide a solution to this problem.

### CITATION LIST

### PATENT LITERATURE

Patent Document 1: WO 2021/060518 A1
Patent Document 2: JP 2014-216555 A
Patent Document 3: JP 2016-063198 A
Patent Document 4: JP H10-223496 A

### NON PATENT LITERATURE

Non-Patent Document 1: Iwamuro, "Progress in High Performance and High Reliability of SiC MOSFETs," proceedings of the Special Open Symposium of the Japan Society of Wide Gap Semiconductors, 2022, the Japan Society of Wide Gap Semiconductors.
Non-Patent Document 2: H. Biard, W. Schwarzenbach, S. Odoul, I. Radu, A. Potier, M. Ferrato, E. Guajioty, "Tailored polycrystalline substrate for SmartSiCTM substrates enabling high performance power devices", ICSCRM 2022
Non-Patent Document 3: Suga, "Surface activated bonding at room temperature and its bonding mechanism", Applied Physics, 89(9), P. 498, 2020, the Japan Society of Applied Physics.
Non-Patent Document 4: Tagai, Tokuhei et al., "Phase Transition and Polytypism among SiC Polytypes," Journal of the Mineralogical Society of Japan, Japan Association of Mineralogical Sciences, Vol. 9, No. 6, 1970, pp. 475-478

### SUMMARY OF INVENTION

### TECHNICAL PROBLEM

In this way, in bonding and separating between a single crystal SiC and a polycrystalline SiC, the following problems have been identified: a diameter of the preexisting single crystal SiC is limited; a considerable time is required to realize a single crystal SiC having 300 mmφ; and when growing SiC on a silicon substrate, a polytype of a crystal is essentially limited to 3C-SiC. Consequently, no method has been available to achieve both an increase in diameter and accommodation of various polytypes of SiC.

Accordingly, the present invention has been made in view of the above-described problem. An object of the present invention is to provide a method for producing a SiC substrate to achieve both an increase in diameter and accommodation of various polytypes of SiC, while being low cost and high quality.

In addition, the present invention has an object of providing a method for producing a semiconductor module, which enables the production of a low-cost and high-quality semiconductor module.

Furthermore, an object of the present invention is to provide a SiC substrate that achieves both an increase in diameter and accommodation of various polytypes of SiC, while being low cost and high quality.

Moreover, an object of the present invention is to provide a semiconductor module of low cost and high quality.

### SOLUTION TO PROBLEM

The present invention has been made to achieve the above-described problem, and provides a method for producing a SiC substrate, the method comprising the steps of:
bonding a 3C-SiC layer of a growth substrate, in which the 3C-SiC layer has been grown on a silicon substrate, to a poly-SiC substrate, being a support substrate, to obtain a bonded substrate;
removing the silicon substrate from the bonded substrate; and
a heat treatment of further subjecting the bonded substrate after the step of removing to a heat treatment to induce a phase transition of the 3C-SiC layer, thereby obtaining the SiC substrate having a SiC layer with a plane orientation different from a plane orientation prior to the heat treatment.

With such a method for producing a SiC substrate, the 3C-SiC layer grown on the silicon substrate is bonded to the poly-SiC, after which the silicon substrate is removed, and the layer is heated to induce the phase transition of the 3C-SiC layer. Consequently, the SiC substrate having various plane orientations can be provided at a lower cost, with higher quality, and in a larger diameter, and this enables the SiC substrate to achieve both an increase in diameter and accommodation of various polytypes of SiC.

In this case, it is possible that the silicon substrate has a plane orientation of <111>.

Consequently, it is possible to reduce lattice mismatch between the silicon substrate and the 3C-SiC layer, as compared to the case where the plane orientation of the silicon substrate is set to a different orientation.

In this case, it is possible that the 3C-SiC layer grown on the silicon substrate has a thickness of 20 to 200 nm.

Consequently, when separating the silicon substrate using hydrogen ion implantation in the step of removing, an acceleration voltage during the hydrogen ion implantation can be reduced, while maintaining the thickness of the 3C-SiC layer required for forming the device, or the like. Moreover, warping of the growth substrate can be suppressed.

In this case, it is possible that the 3C-SiC layer grown on the silicon substrate has a thickness of 50 to 100 nm.

Consequently, this is more advantageous in reducing the acceleration voltage during the hydrogen ion implantation when the silicon substrate is separated by hydrogen ion implantation in the step of removing, while maintaining the thickness of the 3C-SiC layer required for forming the device, or the like. This is also advantageous for suppressing warping of the growth substrate.

In this case, it is possible that the 3C-SiC layer grown on the silicon substrate has a surface roughness Ra of 1 nm or less.

As a result, adhesion between the 3C-SiC layer and the poly-SiC substrate in the step of bonding can be improved.

In this case, it is possible that a substrate shape of the growth substrate is an upward convex shape.

Consequently, it is possible to reduce an unbonded portion in the step of bonding.

In this case, it is possible that the removal of the silicon substrate in the step of removing is performed by separating the silicon substrate utilizing embrittlement effect of hydrogen implantation at an interface between the silicon substrate and the 3C-SiC layer.

As a result, compared with the removal by etching or by grinding and polishing, this process eliminates a need for post-treatment after the step of removing, such as cleaning to remove an etching solution or a polishing agent adhering to the bonded substrate by etching or by grinding and polishing.

In this case, it is possible that the removal of the silicon substrate in the step of removing is performed by etching or by grinding and polishing.

This enables omission of previous steps, such as hydrogen implantation, before the step of removing, compared to a case where the hydrogen implantation is performed.

In this case, it is possible that the method comprises the step of sputtering a silicon thin film onto surfaces of both the 3C-SiC layer and the poly-SiC substrate prior to the step of bonding.

Consequently, bonding between the 3C-SiC layer and the poly-SiC substrate can be performed more reliably without leaving the unbonded portion during the step of bonding.

In this case, it is possible that the method comprises the step of epitaxially growing for further growing 3C-SiC epitaxially on the surface of the 3C-SiC layer after the step of removing.

As a result, the 3C-SiC layer can be further thickened.

In this case, it is possible that in the step of a heat treatment, the bonded substrate is subjected to the heat treatment at a temperature in a range of 1900 to 2100°C to induce the phase transition of the 3C-SiC layer into a 4H-SiC layer.

As a result, the 4H-SiC layer can be obtained as the SiC layer.

In this case, it is possible that in the step of a heat treatment, the bonded substrate is subjected to the heat treatment at a temperature in a range of 2000 to 2050°C to induce the phase transition of the 3C-SiC layer into a 4H-SiC layer.

As a result, the 4H-SiC layer can be more reliably obtained as the SiC layer.

In this case, it is possible that in the step of a heat treatment, the bonded substrate is subjected to the heat treatment at a temperature of 2200°C or higher to induce the phase transition of the 3C-SiC layer into a 6H-SiC layer.

As a result, the 6H-SiC layer can be obtained as the SiC layer.

In this case, it is possible that in the step of a heat treatment, the bonded substrate is subjected to the heat treatment at a temperature of 2300°C or higher to induce the phase transition of the 3C-SiC layer into a 6H-SiC layer.

As a result, the 6H-SiC layer can be obtained more reliably as the SiC layer.

Moreover, the present invention provides a method for producing a semiconductor module, the method comprising the step of forming a device to obtain the semiconductor module by forming a semiconductor device on the SiC substrate produced according to the production method described above.

According to such a method for producing a semiconductor module, the low-cost, high-quality SiC substrate is employed, thereby enabling the production of a low-cost, high-quality semiconductor module.

Furthermore, the present invention provides a SiC substrate comprising: a poly-SiC substrate; and a SiC layer bonded to the poly-SiC substrate, wherein the SiC layer is a 4H-SiC layer or a 6H-SiC layer.

By using such a SiC substrate, the SiC substrate having various plane orientations can be provided at a lower cost, with higher quality, and in a larger diameter. As a result, the SiC substrate achieves both an increase in diameter and accommodation of various polytypes of SiC.

Moreover, the present invention provides a semiconductor module comprising the SiC substrate described above.

In such a semiconductor module, a low-cost, high-quality SiC substrate is provided, and the semiconductor module can also be realized at low cost with high quality.

### ADVANTAGEOUS EFFECTS OF INVENTION

As described above, according to the inventive method for producing a SiC substrate, it is possible to achieve both an increase in diameter and accommodation of various polytypes of SiC, thereby enabling the production of a low-cost, high-quality SiC substrate.

Moreover, according to the inventive method for producing a semiconductor module, a high-quality semiconductor module can be produced using a low-cost, high-quality SiC substrate.

Moreover, according to the present invention, it is possible to provide a SiC substrate that achieves both the increase in diameter and accommodation of various polytypes of SiC, and is low in cost and high in quality.

Furthermore, according to the present invention, it is possible to provide a semiconductor module that is low in cost and high in quality.

### BRIEF DESCRIPTION OF DRAWINGS

[FIG. 1] is a schematic view of a SiC substrate according to the present invention.
[FIG. 2] is a flow diagram of a method for producing a SiC substrate according to the present invention.
[FIG. 3] is a flow diagram of another method for producing a SiC substrate according to the present invention.

### DESCRIPTION OF EMBODIMENTS

Hereinafter, the present invention will be described in detail. However, the present invention is not limited thereto.

As described above, a method for producing a SiC substrate that achieves both an increase in diameter and accommodation of various polytypes of SiC, while being low in cost and high in quality, has been desired.

To solve the above problem, the present inventors have earnestly studied and, as a result, found that by employing a method for producing a SiC substrate, a low-cost, high-quality SiC substrate to achieve both an increase in diameter and accommodation of various polytypes of SiC can be produced. This method includes steps of: bonding a 3C-SiC layer of a growth substrate, in which the 3C-SiC layer has been grown on a silicon substrate, to a poly-SiC substrate, being a support substrate, to obtain a bonded substrate; removing the silicon substrate from the bonded substrate; and a heat treatment of further subjecting the bonded substrate after the step of removing to a heat treatment to induce a phase transition of the 3C-SiC layer, thereby obtaining the SiC substrate having a SiC layer with a plane orientation different from a plane orientation prior to the heat treatment. Thus, the present invention has been completed.

Moreover, as described above, a method for producing a low-cost, high-quality semiconductor module has been desired.

To solve the above problem, the present inventors have earnestly studied and, as a result, found that by employing a method for producing a semiconductor module, a low-cost, high-quality semiconductor module can be produced. This method includes the step of forming a device to obtain the semiconductor module by forming a semiconductor device on the SiC substrate produced according to the production method described above. Thus, the present invention has been completed.

Moreover, as described above, a SiC substrate that achieves both an increase in diameter and accommodation of various polytypes of SiC, while being low in cost and high in quality, has been desired.

To solve the above problem, the present inventors have earnestly studied and, as a result, found that by employing a SiC substrate that includes a poly-SiC substrate, and a SiC layer bonded to the poly-SiC substrate, in which the SiC layer is a 4H-SiC layer or a 6H-SiC layer, both an increase in diameter and accommodation of various polytypes of SiC can be achieved, and such a SiC substrate is low in cost and high in quality. Thus, the present invention has been completed.

Furthermore, as described above, a low-cost, high-quality semiconductor module has been desired.

To solve the above problem, the present inventors have earnestly studied and, as a result, found that by employing a semiconductor module that includes the SiC substrate as described above, a low-cost, high-quality semiconductor module is provided. Thus, the present invention has been completed.

Hereinafter, the embodiment of the present invention will be described.

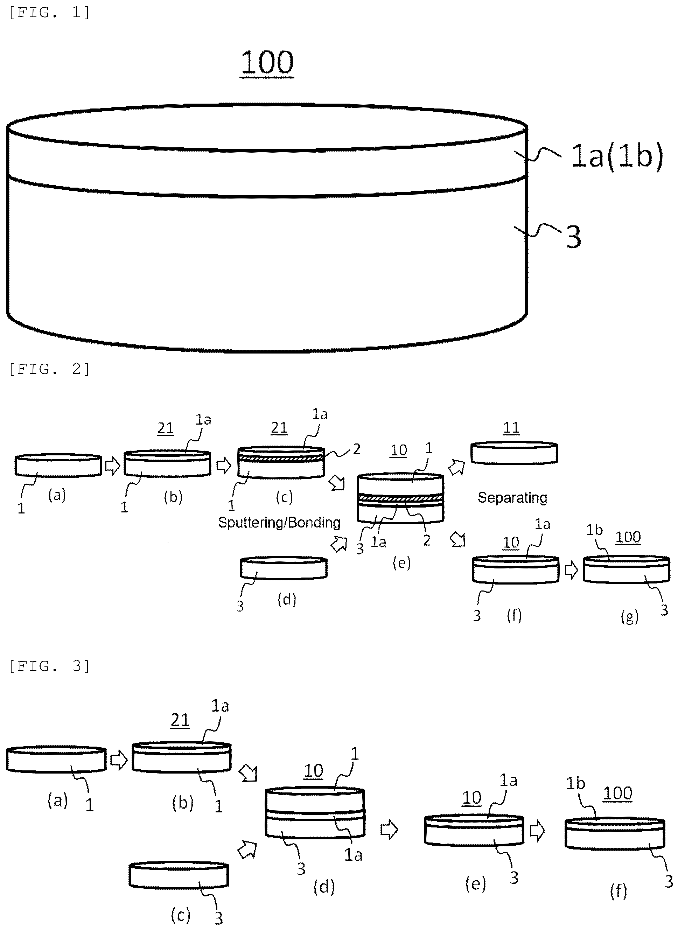

First, a configuration of the SiC substrate according to the embodiment of the present invention will be described with reference to FIG. 1.

As shown in FIG. 1, a SiC substrate 100 according to the embodiment of the present invention is provided with a support substrate 3 composed of poly-SiC (poly-SiC substrate), and a SiC layer 1b bonded to a surface of the support substrate 3.

The support substrate 3 is a substrate to support the SiC layer 1b. Note that a concrete example of the support substrate 3 includes poly-SiC (a SiC substrate produced by sintering or a polycrystalline SiC substrate) as an option when considering prices, etc.

The SiC layer 1b is a single crystal SiC layer bonded to the surface of the support substrate 3. This bonding may be direct bonding between the unprocessed bonding surfaces of the SiC layer 1b and the support substrate 3, or silicon thin films have been grown on the bonding surfaces, enabling the strong bonding via the silicon thin films.

The SiC layer 1b is a 4H-SiC layer or a 6H-SiC layer.

More specifically, this SiC layer 1b is obtained by subjecting the 3C-SiC layer 1a to a heat treatment to induce a phase transition into 4H-SiC or 6H-SiC. Note that, prior to this phase transition, 3C-SiC may be epitaxially grown on the 3C-SiC layer 1a, or the layer may be used as is.

In this way, the SiC substrate 100 has the SiC layer 1b composed of either 4H-SiC or 6H-SiC bonded to the support substrate 3 composed of low-cost poly-SiC, thereby enabling both an increase in diameter and accommodation of various polytypes of SiC at low cost. Moreover, the SiC layer 1b is either the 4H-SiC layer or the 6H-SiC layer, resulting in high-quality and high-reliability.

It is preferable that the thickness of the SiC layer 1b is approximately 50 to 100 nm in thickness, in which a layer readily maintains shape thereof. As for the maximum value of a preferable thickness, 100 nm, the thickness of this level is preferable in consideration of productivity and the use of a high-current ion implantation apparatus when the 3C-SiC layer 1a is separated by hydrogen ion implantation to be transferred from a silicon substrate 1 to the support substrate 3. Moreover, when the thickness is within this range, the 3C-SiC layer 1a suppresses warping of the SiC substrate 100, thereby reducing the likelihood of bonding failure during transfer of the 3C-SiC layer 1a.

Next, with reference to FIG. 1, a configuration of a semiconductor module will be described.

The semiconductor module is provided with the SiC substrate 100 shown in FIG. 1.

Examples of a specific semiconductor module include SiC substrate 100, in particular, a substrate on which a desired semiconductor device is formed on the SiC layer 1b produced by inducing a phase transition of the 3C-SiC layer 1a into 4H-SiC or 6H-SiC. It is evident that the semiconductor module may be diced into chips.

By including the SiC substrate 100 which is low in cost, high in quality, and high in reliability, and also achieves both an increase in diameter and accommodation of various polytypes of SiC, the semiconductor module also becomes a low-cost, high-quality, and highly reliable device.

Next, with reference to FIG. 2, an overview of the inventive method for producing a SiC substrate 100 will be described.

First, a growth substrate 21, on which the 3C-SiC layer 1a has been grown on the silicon substrate, is provided.

Specifically, as shown in FIG. 2(a), the silicon substrate 1 of a single crystal is provided in the first place. Here, it is preferable to provide the substrate having a diameter of 300 mm or more, since such a large diameter SiC substrate is not available. Moreover, a plane orientation is preferably set to <111> in consideration of surface atomic density (interatomic distance) being closer to that of SiC.

The 3C-SiC layer 1a is epitaxially grown on this silicon substrate 1, as shown in FIG. 2(b), to obtain the growth substrate 21.

The 3C-SiC layer 1a grown on the silicon substrate 1 preferably has a thickness of 20 to 200 nm.

As a result, while ensuring the required thickness of the 3C-SiC layer 1a for forming the device, etc., an acceleration voltage during hydrogen ion implantation for separation using hydrogen ion implantation can be reduced in the subsequent step of removing. Moreover, warping of the growth substrate 21 can be suppressed.

It is more preferable that the 3C-SiC layer 1a has a thickness of 50 to 100 nm.

As a result, while ensuring the thickness of the 3C-SiC layer 1a required for forming the device, etc., it becomes more advantageous in reducing the acceleration voltage during hydrogen ion implantation for separation using hydrogen ion implantation in the step of removing. Moreover, it becomes advantageous to suppress warping of the growth substrate 21.

In addition, when surface roughness Ra of the 3C-SiC layer 1a grown on the silicon substrate is set to 1 nm or less, adhesion between the 3C-SiC layer 1a and the support substrate 3 can be improved in the subsequent step in which the 3C-SiC layer 1a is bonded to the support substrate 3.

Furthermore, by forming a substrate shape of the growth substrate 21 into an upwardly convex shape, in which the 3C-SiC layer 1a side has a convex shape, an unbonded portion can be further reduced in the subsequent bonding step. Note that the term upwardly convex shape, as used herein, refers to, e.g., a shape having a BOW of 10 µm or more.

Next, as shown in FIG. 2(c), by implanting hydrogen ions into an interface between the 3C-SiC layer 1a and the silicon substrate 1, a hydrogen embrittlement layer 2 is formed. By adjusting the acceleration voltage during the ion implantation at this time, it is possible to form the hydrogen embrittlement layer 2 at a predetermined depth even when the thickness of the 3C-SiC layer 1a is altered.

More specifically, the hydrogen ions are implanted into the growth substrate 21, in which the 3C-SiC layer 1a has been grown on the silicon substrate 1, from the 3C-SiC layer 1a side. At this time, when the 3C-SiC layer 1a has a thin thickness of approximately 100 nm, the hydrogen ions required for the separation can be implanted in a short time using a high-current ion implanter.

Moreover, the hydrogen embrittlement layer 2 at this time is formed at the interface between the 3C-SiC layer 1a and the silicon substrate 1; more specifically, it is desirable that the hydrogen embrittlement layer 2 is formed in the silicon substrate 1 directly under the 3C-SiC layer 1a. In this way, the need for the step of removing an excessive silicon layer is eliminated in the subsequent step of removing. In the following description, unless otherwise specified, a case where the hydrogen embrittlement layer 2 is formed in the silicon substrate 1 directly under the 3C-SiC layer 1a will be described as an example.

Next, as shown in FIG. 2(d), another substrate is provided as the support substrate 3, different from the silicon substrate 1 on which 3C-SiC has been grown. This support substrate 3 is made of sintered SiC produced by sintering or polycrystalline SiC, etc., in consideration of cost, etc., and is referred to as the poly-SiC substrate.

In this way, by employing the poly-SiC substrate as the support substrate 3, it becomes possible to achieve an increase to the diameter of 300 mm or larger, which is unavailable by a sublimation method, and the like, and a significant reduction of the production cost. Moreover, it has been reported that the use of poly-SiC substrate as the support substrate 3 is more effective in reducing a substrate resistivity (Non-Patent Document 2), and thus, in addition to a cost advantage, it is highly effective when considering an application for a vertical device.

Next, as shown in FIG. 2(e), a hydrogen ion-implanted surface of the growth substrate 21, on which the 3C-SiC layer 1a has been grown on the silicon substrate 1, i.e., the 3C-SiC layer 1a, is bonded to the support substrate 3 to obtain a bonded substrate 10 (Step of bonding).

When bonding, the 3C-SiC layer 1a and the support substrate 3 may be directly bonded at room temperature. Alternatively, silicon thin films are formed on the surfaces of the 3C-SiC layer 1a and the support substrate 3, both prior to the step of bonding, by sputtering (Step of sputtering), and these may then be bonded by bonding at room temperature, and the like, to obtain the bonded substrate 10. That is, by sputtering silicon onto the bonding surfaces and by bonding via the silicon thin films, it becomes possible to achieve bonding between the SiC substrates without leaving the unbonded portion.

As a specific method for sputtering, a method for irradiating a silicon target with Ar ions to form a film is effective in that heating the substrate at high temperature is not required, and the SiC surfaces on the bonded surface are not roughened.

Note that it has been found that the roughness of the bonding surfaces at bonding is preferably 1 nm or less (Non-Patent Document 3).

Next, as shown in FIG. 2(f), the bonded substrate 10 is subjected to the heat treatment, and separation is performed at the hydrogen embrittlement layer 2, into which hydrogen ions have previously been implanted, thereby removing the silicon substrate 1 from the bonded substrate 10 (Step of removing).

Note that a method for separating by inserting a thin metal-like object from the side may be performed.

A heat treatment temperature at this time may be sufficient at a temperature of approximately 400 to 600°C due to the formation of the hydrogen embrittlement layer 2 in the silicon layer. As described above, the separation method other than heating may also be achieved by inserting, e.g., a metal thin blade-like object into the hydrogen embrittlement layer 2.

By separating in this way, the 3C-SiC layer 1a on the surface of the silicon substrate 1, on which the 3C-SiC layer 1a has been grown, is transferred onto the support substrate 3. Accordingly, the silicon substrate 1 serves as the separation substrate 11, being a substrate from which the 3C-SiC layer 1a on the surface has been removed, and removed from the bonded substrate 10.

In this way, the silicon substrate 1 is removed in the step of removing as a separation of the silicon substrate 1 utilizing the embrittlement effect of hydrogen implantation at the interface between the silicon substrate 1 and the 3C-SiC layer 1a. As a result, post-treatment after the step of removing, such as cleaning to implement removal or related measures of an etching solution or a polishing agent, adhering to the bonded substrate 10 during etching, or grinding and polishing becomes unnecessary, compared with a case where the silicon substrate 1 is removed from the bonded substrate 10 by etching, or grinding and polishing. However, the step of removing can alternatively be performed by etching, or grinding and polishing, as described later.

Note that, after the step of removing, an additional 3C-SiC epitaxial growth may be performed on the surface of the 3C-SiC layer 1a as the step of epitaxially growing. In this case, the 3C-SiC layer 1a can be formed to a greater thickness.

The bonded substrate 10, from which the silicon substrate 1 is removed in this way, is subsequently subjected to the heat treatment at a high temperature. This induces the phase transition of the 3C-SiC layer 1a transferred onto the support substrate 3 into 4H-SiC or 6H-SiC, which becomes the SiC layer 1b, as shown in FIG. 2(g), and the SiC substrate 100 having the SiC layer 1b is finally obtained, in which the SiC layer 1b has a different plane orientation from that prior to the heat treatment (Step of a heat treatment).

3C-SiC is stable at low temperatures and is converted to 4H-SiC or 6H-SiC as the heating temperature increases (Non-Patent Document 4). Accordingly, the use of 3C-SiC as an initial material is advantageous in that 3C-SiC can be grown on the silicon substrate 1 and also converted to 4H-SiC or 6H-SiC by the phase transition.

When inducing the phase transition of the SiC layer 1b into the 4H-SiC layer, the heating temperature at this time is preferably in a range of 1900 to 2100°C, more preferably, the heating temperature is in a range of 2000 to 2050°C.

As for the heating temperature, reference may be made to Non-Patent Document 4. However, when causing the phase transition of the SiC layer 1b into the 6H-SiC layer, a heating temperature at 2200°C or higher is preferable, and a temperature range of 2300°C or higher is more preferable. The upper limit of the temperature is not particularly limited, but can be 2500°C or lower.

Note that when performing the step of epitaxially growing for further growing 3C-SiC epitaxially on the surface of the 3C-SiC layer 1a after the step of removing, it is possible that the SiC substrate 100 is finally obtained by subjecting the 3C-SiC layer 1a to heat treatment and then causing the phase transition of the 3C-SiC layer 1a into 4H-SiC or 6H-SiC. In this case, the 3C-SiC layer 1a can be made thicker, which also allows the SiC layer 1b to be made thicker.

Moreover, an atmosphere during the heating step is, for example, a hydrogen atmosphere or an Ar (argon) atmosphere. A heating time may be a time required for the phase transition, for example, approximately 1 hour. The upper limit for the heating time is, for example, 20 hours. A pressure during the heating step is, for example, atmospheric pressure.

Note that, by performing the device formation step to obtain the semiconductor module, in which the semiconductor device is formed on the SiC substrate 100 produced through the above steps, the semiconductor module can be produced.

Next, as an example of another production flow of the inventive method for producing a SiC substrate 100, a production method without performing separation at the hydrogen embrittlement layer 2 through hydrogen ion implantation will be described using FIG. 3. Initially, the growth substrate 21 on which the 3C-SiC layer 1a has been grown on the silicon substrate 1 is provided.

Specifically, the silicon substrate 1 is first provided as shown in FIG. 3(a). Here, it is preferable to employ a substrate having a diameter of 300 mm or larger since such a large diameter SiC substrate is not available. Moreover, it is preferable that the silicon substrate 1 has a plane orientation of <111> in consideration of that the surface atomic density (interatomic distance) of the substrate is closer to that of SiC.

Next, as shown in FIG. 3(b), epitaxial growth is performed on this silicon substrate 1 to grow the 3C-SiC layer 1a, thereby obtaining the growth substrate 21.

Subsequently, as shown in FIG. 3(c), another substrate that is different from the silicon substrate 1 on which 3C-SiC has been grown is provided as the support substrate 3. This support substrate 3 is made of sintered SiC produced by sintering or polycrystalline SiC, etc., in consideration of cost, etc., and is a poly-SiC substrate.

Next, as shown in FIG. 3(d), the surface of the 3C-SiC layer 1a of the silicon substrate 1 on which 3C-SiC has been grown is bonded to the support substrate 3 (the step of bonding). At this time, the surface of the 3C-SiC layer 1a may be directly bonded to the support substrate 3, or the silicon thin films may be formed on the surface of the 3C-SiC layer 1a and on the support substrate 3, after which these are bonded to obtain the bonded substrate 10.

One example of a bonding method is the bonding at room temperature. Note that when the silicon thin films, prior to the bonding, are formed using the sputtering method, where Ar ions are irradiated onto a silicon target for film-forming, the need for high-temperature heating of the substrate is eliminated, and the SiC surface on the bonding surface is not roughened; therefore, this method is effective.

Next, as shown in FIG. 3(e), the silicon substrate 1 of the bonded substrate 10 is removed by polishing and grinding, or by etching, or the like. By removing the silicon substrate 1 in this way, the 3C-SiC layer 1a on the surface of the silicon substrate 1, on which 3C-SiC has been grown, is transferred onto the support substrate 3, and the bonded substrate 10 from which the silicon substrate 1 is removed can be obtained.

The bonded substrate 10, from which the silicon substrate 1 is removed in this way, is subjected to the heat treatment at a high temperature to induce the phase transition of the 3C-SiC layer 1a, which has been transferred onto the support substrate 3, into 4H-SiC or 6H-SiC, which becomes the SiC layer 1b, as shown in FIG. 3(f), and the SiC substrate 100 is finally obtained.

Alternatively, at this time, 3C-SiC may be epitaxially grown on the 3C-SiC layer 1a in advance, and then heat-treated to induce the phase transition of the 3C-SiC layer 1a into 4H-SiC or 6H-SiC, thereby finally obtaining the SiC substrate 100.

In this way, in the present invention, the 3C-SiC layer 1a grown on the silicon substrate 1 having a large diameter of 300 mm or larger is bonded to the poly-SiC substrate, being the support substrate 3. Subsequently, by removing the silicon substrate 1, a substrate made solely of SiC is produced. Furthermore, by subjecting the substrate to heat treatment to induce the phase transition of the 3C-SiC layer 1a, the SiC substrate 100 having various plane orientations can be provided at a lower cost, with higher quality, and in a larger diameter.

In addition, by transferring the 3C-SiC layer 1a grown on the silicon substrate to the poly-SiC substrate, and by further inducing the phase transition of the 3C-SiC layer 1a, it becomes possible not only to provide the SiC substrate 100 having a large diameter but also to produce a vertical device that has been impossible to realize using 3C-SiC on Si.

### EXAMPLE

Hereinafter, the present invention will be specifically described with reference to Examples. However, the present invention is not limited thereto.

### (Example 1)

Initially, a single crystal substrate having a main surface plane orientation of <111>, a diameter of 300 mm, a thickness of 775 µm, p-type, and a resistivity of 10 Ω·cm was provided as a silicon substrate 1. A 3C-SiC layer 1a was grown thereon to a thickness of 100 nm in a reduced-pressure CVD furnace under conditions of 1080°C/5 Torr (666.612 Pa) using trimethylsilane as a raw material gas. Furthermore, hydrogen ions having an acceleration energy of 10 keV were implanted at 1.0×10¹⁷ atoms/cm² at an interface between the silicon substrate 1 and the 3C-SiC layer 1a.

Next, a poly-SiC substrate, having the same diameter as the silicon substrate 1, was provided as a support substrate 3. Silicon films were formed by sputtering onto both this substrate and the surface on which the 3C-SiC layer 1a had previously been grown, by irradiating a silicon target with Ar ions. At this time, a film thickness of the silicon thin film was set to 20 nm. Subsequently, bonding at room temperature was performed to obtain a bonded substrate 10.

Thereafter, heat treatment was performed at 650°C, and the silicon substrate 1 was separated and removed from the bonded substrate 10.

On this bonded substrate 10, 3C-SiC was epitaxially grown using a reduced pressure CVD apparatus with trimethylsilane as a raw material gas as the step of epitaxially growing. Subsequently, by annealing the substrate at 2000°C for 1 hour under a hydrogen atmosphere, a SiC substrate 100 having a SiC layer 1b, of which the 3C-SiC layer 1a had undergone a phase transition into 4H-SiC, was obtained.

### (Example 2)

Initially, a single crystal substrate having a main surface plane orientation of <111>, a diameter of 300 mm, a thickness of 775 µm, p-type, and a resistivity of 10 Ω·cm was provided as a silicon substrate 1. A 3C-SiC layer 1a was grown thereon to a thickness of 100 nm in a reduced-pressure CVD furnace under conditions of 1080°C/5 Torr (666.612 Pa) using trimethylsilane as a raw material gas.

Next, a poly-SiC substrate, having the same diameter as the silicon substrate 1, was provided as a support substrate 3. Silicon films were formed by sputtering onto both this substrate and the surface on which 3C-SiC had previously been grown, by irradiating a silicon target with Ar ions. At this time, the silicon thin film had a thickness of 20 nm.

Subsequently, bonding at room temperature between the silicon thin films formed respectively was performed to obtain a bonded substrate 10.

Thereafter, the silicon substrate 1 of the bonded substrate 10 was etched and removed using a spin etching apparatus with hydrofluoric acid as an etching solution.

On the bonded substrate 10 where the silicon substrate 1 had been removed, 3C-SiC was epitaxially grown using a reduced pressure CVD apparatus with trimethylsilane as a raw material gas as the step of epitaxially growing. Subsequently, by annealing the substrate at 2000°C for 1 hour under a hydrogen atmosphere, a SiC substrate 100 having a SiC layer 1b, of which the 3C-SiC layer 1a had undergone a phase transition into 4H-SiC, was obtained.

As described above, according to Example of the present invention, the large-diameter SiC substrate 100 having a 4H-SiC layer was successfully produced. This was achieved by transferring the 3C-SiC layer 1a grown on the silicon substrate onto the poly-SiC substrate, and then heating the 3C-SiC layer 1a to induce the phase transition of the 3C-SiC layer 1a.

The present description includes the following embodiments.
[1]: A method for producing a SiC substrate, the method comprising the steps of:
   bonding a 3C-SiC layer of a growth substrate, in which the 3C-SiC layer has been grown on a silicon substrate, to a poly-SiC substrate, being a support substrate, to obtain a bonded substrate;
   removing the silicon substrate from the bonded substrate; and
   a heat treatment of further subjecting the bonded substrate after the step of removing to a heat treatment to induce a phase transition of the 3C-SiC layer, thereby obtaining the SiC substrate having a SiC layer with a plane orientation different from a plane orientation prior to the heat treatment.
[2]: The method for producing a SiC substrate according to the above [1], wherein
   the silicon substrate has a plane orientation of <111>.
[3]: The method for producing a SiC substrate according to the above [1] or [2], wherein
   the 3C-SiC layer grown on the silicon substrate has a thickness of 20 to 200 nm.
[4]: The method for producing a SiC substrate according to any of the above [1] to [3], wherein
   the 3C-SiC layer grown on the silicon substrate has a thickness of 50 to 100 nm.
[5]: The method for producing a SiC substrate according to any of the above [1] to [4], wherein
   the 3C-SiC layer grown on the silicon substrate has a surface roughness Ra of 1 nm or less.
[6]: The method for producing a SiC substrate according to any of the above [1] to [5], wherein
   a substrate shape of the growth substrate is an upward convex shape.
[7]: The method for producing a SiC substrate according to any of the above [1] to [6], wherein
   the removal of the silicon substrate in the step of removing is performed by separating the silicon substrate utilizing embrittlement effect of hydrogen implantation at an interface between the silicon substrate and the 3C-SiC layer.
[8]: The method for producing a SiC substrate according to any of the above [1] to [6], wherein
   the removal of the silicon substrate in the step of removing is performed by etching or by grinding and polishing.
[9]: The method for producing a SiC substrate according to any of the above [1] to [8], the method comprising the step of sputtering a silicon thin film onto surfaces of both the 3C-SiC layer and the poly-SiC substrate prior to the step of bonding.
[10]: The method for producing a SiC substrate according to any of the above [1] to [9], the method comprising the step of epitaxially growing for further growing 3C-SiC epitaxially on the surface of the 3C-SiC layer after the step of removing.
[11]: The method for producing a SiC substrate according to any of the above [1] to [10], wherein
   in the step of a heat treatment, the bonded substrate is subjected to the heat treatment at a temperature in a range of 1900 to 2100°C to induce the phase transition of the 3C-SiC layer into a 4H-SiC layer.
[12]: The method for producing a SiC substrate according to any of the above [1] to [10], wherein
   in the step of a heat treatment, the bonded substrate is subjected to the heat treatment at a temperature in a range of 2000 to 2050°C to induce the phase transition of the 3C-SiC layer into a 4H-SiC layer.
[13]: The method for producing a SiC substrate according to any of the above [1] to [10], wherein
   in the step of a heat treatment, the bonded substrate is subjected to the heat treatment at a temperature of 2200°C or higher to induce the phase transition of the 3C-SiC layer into a 6H-SiC layer.
[14]: The method for producing a SiC substrate according to any of the above [1] to [10], wherein
   in the step of a heat treatment, the bonded substrate is subjected to the heat treatment at a temperature of 2300°C or higher to induce the phase transition of the 3C-SiC layer into a 6H-SiC layer.
[15]: A method for producing a semiconductor module, the method comprising the step of forming a device to obtain the semiconductor module by forming a semiconductor device on the SiC substrate produced according to the production method according to any of the above [1] to [14].
[16]: A SiC substrate comprising:
   a poly-SiC substrate; and
   a SiC layer bonded to the poly-SiC substrate, wherein
   the SiC layer is a 4H-SiC layer or a 6H-SiC layer.
[17]: A semiconductor module comprising the SiC substrate according to the above [16].

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a SiC substrate, the method comprising the steps of:
bonding a 3C-SiC layer of a growth substrate, in which the 3C-SiC layer has been grown on a silicon substrate, to a poly-SiC substrate, being a support substrate, to obtain a bonded substrate;
removing the silicon substrate from the bonded substrate; and
a heat treatment of further subjecting the bonded substrate after the step of removing to a heat treatment to induce a phase transition of the 3C-SiC layer, thereby obtaining the SiC substrate having a SiC layer with a plane orientation different from a plane orientation prior to the heat treatment.

2. The method for producing a SiC substrate according to claim 1, wherein
the silicon substrate has a plane orientation of <111>.

3. The method for producing a SiC substrate according to claim 1, wherein
the 3C-SiC layer grown on the silicon substrate has a thickness of 20 to 200 nm.

4. The method for producing a SiC substrate according to claim 1, wherein
the 3C-SiC layer grown on the silicon substrate has a thickness of 50 to 100 nm.

5. The method for producing a SiC substrate according to claim 1, wherein
the 3C-SiC layer grown on the silicon substrate has a surface roughness Ra of 1 nm or less.

6. The method for producing a SiC substrate according to claim 1, wherein
a substrate shape of the growth substrate is an upward convex shape.

7. The method for producing a SiC substrate according to claim 1, wherein
the removal of the silicon substrate in the step of removing is performed by separating the silicon substrate utilizing embrittlement effect of hydrogen implantation at an interface between the silicon substrate and the 3C-SiC layer.

8. The method for producing a SiC substrate according to claim 1, wherein
the removal of the silicon substrate in the step of removing is performed by etching or by grinding and polishing.

9. The method for producing a SiC substrate according to claim 1, the method comprising the step of sputtering a silicon thin film onto surfaces of both the 3C-SiC layer and the poly-SiC substrate prior to the step of bonding.

10. The method for producing a SiC substrate according to claim 1, the method comprising the step of epitaxially growing for further growing 3C-SiC epitaxially on the surface of the 3C-SiC layer after the step of removing.

11. The method for producing a SiC substrate according to any one of claims 1 to 10, wherein
in the step of a heat treatment, the bonded substrate is subjected to the heat treatment at a temperature in a range of 1900 to 2100°C to induce the phase transition of the 3C-SiC layer into a 4H-SiC layer.

12. The method for producing a SiC substrate according to any one of claims 1 to 10, wherein
in the step of a heat treatment, the bonded substrate is subjected to the heat treatment at a temperature in a range of 2000 to 2050°C to induce the phase transition of the 3C-SiC layer into a 4H-SiC layer.

13. The method for producing a SiC substrate according to any one of claims 1 to 10, wherein
in the step of a heat treatment, the bonded substrate is subjected to the heat treatment at a temperature of 2200°C or higher to induce the phase transition of the 3C-SiC layer into a 6H-SiC layer.

14. The method for producing a SiC substrate according to any one of claims 1 to 10, wherein
in the step of a heat treatment, the bonded substrate is subjected to the heat treatment at a temperature of 2300°C or higher to induce the phase transition of the 3C-SiC layer into a 6H-SiC layer.

15. A method for producing a semiconductor module, the method comprising the step of forming a device to obtain the semiconductor module by forming a semiconductor device on the SiC substrate produced according to the production method according to claim 1.

16. A SiC substrate comprising:
a poly-SiC substrate; and
a SiC layer bonded to the poly-SiC substrate, wherein
the SiC layer is a 4H-SiC layer or a 6H-SiC layer.

17. A semiconductor module comprising the SiC substrate according to claim 16.
